# EUROPEAN PATENT APPLICATION

(11) **EP 1 580 819 A2**
(43) Date of publication of application: **28.09.2005**
(21) Application number: 05005633.2
(22) Date of filing: 15.03.2005
(51) Int. Cl.: H01L 35/32, H01L 35/04

(54) **Thermoelectric device**

(30) Priority: 25.03.2004 JP 2004090011
(71) Applicant: KABUSHIKI KAISHA TOSHIBA, Tokyo (JP)
(72) Inventor: Tateyama, Kazuki, 1-1 Shibaura 1-chome Minato-ku Tokyo (JP); Sogou, Takahiro, 1-1 Shibaura 1-chome Minato-ku Tokyo (JP); Iguchi, Tomohiro, 1-1 Shibaura 1-chome Minato-ku Tokyo (JP); Hanada, Hiroyoshi, 1-1 Shibaura 1-chome Minato-ku Tokyo (JP); Saito, Yasuhito, 1-1 Shibaura 1-chome Minato-ku Tokyo (JP); Arakawa, Masayuki, 1-1 Shibaura 1-chome Minato-ku Tokyo (JP); Kondo, Naruhito, 1-1 Shibaura 1-chome Minato-ku Tokyo (JP); Tsuneoka, Osamu, 1-1 Shibaura 1-chome Minato-ku Tokyo (JP)
(74) Representative: HOFFMANN EITLE

(57) **Abstract**

In a thermoelectric device, metal fiber nets as conductive members having elasticity are placed between first electrodes and thermoelectric elements, in order to increase productivity and make it possible to reduce variations in performance without impairing the reliability of a slidable structure even if each component is heated to be thermally deformed. This placement prevents the temperature of the metal fiber nets from becoming high in the operation of the thermoelectric device and prevents the elasticity of the metal fiber nets from being lost. Further, this constitution eliminates the necessity for bonding the first electrodes to the thermoelectric elements using solder. Moreover, the elasticity of the metal fiber nets makes it possible to accommodate variations in height among the respective thermoelectric elements when the thermoelectric device is assembled.

## Description

### CROSS-REFERENCE TO RELATED APPLICATIONS

This application is based upon and claims the benefit of priority from Japanese Patent Application No. 2004-90011 filed on March 25, 2004; the entire contents of which are incorporated herein by reference.

### BACKGROUND OF THE INVENTION

### 1. Field of the Invention

The present invention relates to a thermoelectric device in which a plurality of thermoelectric elements are connected in series electrically and in parallel thermally. In particular, the present invention relates to a technology for increasing the reliability of a structure and productivity thereof.

### 2. Description of the Related Art

Thermoelectric devices are devices utilizing thermoelectric effects, such as the Thomson effect, the Peltier effect, the Seebeck effect, and the like. As temperature regulation units configured to convert electricity into heat, the thermoelectric devices have been already put into mass production. Further, also as electric power generation units configured to convert heat into electricity, the thermoelectric devices are being researched and developed. Generally, in a thermoelectric device, a plurality of thermoelectric elements are connected in series electrically and arranged in parallel thermally, first electrodes are attached to the end portions of the respective thermoelectric elements on the heat radiation side, and second electrodes are attached to the end portions of the respective thermoelectric elements on the heat absorption side (refer to Japanese Unexamined Patent Publication No. 2002-232028).

In order to approximate the electric power generation efficiency of the thermoelectric device to those of the thermoelectric elements themselves, it is necessary to perform heat supply to the heat absorption-side end portions of the thermoelectric elements and perform heat radiation from the heat radiation-side end portions of the thermoelectric elements without loss. Accordingly, for a heat radiation-side insulating substrate and a heat absorption-side insulating substrate, ceramic substrates that are excellent in heat conduction are used. Moreover, the first and second electrodes are made of a material having low electric resistance.

Since the thermoelectric device performs a thermoelectric conversion operation when heated, each component is thermally expanded in operation, compared to the component at room temperature. At this time, the respective deformation amounts of the components are different from each other, due to differences in linear expansion coefficient among the respective components and the temperature difference between the heat absorption side and the heat radiation side. There have been cases where the bonding portions of the thermoelectric elements and the thermoelectric elements are easily damaged due to the above-described differences in thermal deformation amounts.

In order to prevent this, a constitution has been adopted heretofore in which the first electrodes on the heat radiation side and the thermoelectric elements are bonded with solder and in which conductive mesh members having elasticity are placed between the second electrodes on the heat absorption side and the second electrodes. That is, a slidable structure has been adopted in which the second electrodes and the thermoelectric elements are thermally and electrically connected not by solder bonding but by just bringing the second electrodes and the thermoelectric elements into contact with each other by placing conductive mesh members having elasticity therebetween, thus reducing the influence of deformation of each component.

However, since the thermoelectric device operates at high temperature, there has been a following problem: the elasticity of the conductive members placed between the second electrodes on the heat absorption side and the thermoelectric elements is significantly deteriorated due to high temperature in the operation of the thermoelectric device, and the reliability of the slidable structure is therefore lowered after the thermoelectric device has been used over a long period.

Moreover, since it takes a long time to bond the first electrodes and the thermoelectric elements with solder, there has been a problem that productivity is low. Furthermore, the thermoelectric elements move horizontally and vertically during solder bonding, and this causes variations in height among the respective thermoelectric elements. Accordingly, there has been a problem that variations in performance among thermoelectric devices occur.

### SUMMARY OF THE INVENTION

An object of the present invention is to provide a thermoelectric device in which the reliability of a slidable structure is not impaired even if each component is thermally deformed, which has excellent productivity, and in which variations in performance can be reduced.

A thermoelectric device of the present invention includes: an insulating substrate having a plurality of first electrodes; a plurality of conductive members placed on the first electrodes, each conductive member having elasticity; a plurality of thermoelectric elements placed in a state where one end faces thereof are in contact with the conductive members respectively; a plurality of second electrodes placed to come into contact with other end faces of the thermoelectric elements respectively; a lid configured to hold the first electrodes, the thermoelectric elements, and the second electrodes in a space between the lid and the insulating substrate, the lid being placed to apply pressure from above the second electrodes; and a coupling member configured to specify a relative position between the insulating substrate and the lid.

In the present invention, the conductive members having elasticity are placed between the first electrodes, which are placed on the heat radiation side where the temperature is lower, and the thermoelectric elements, so that the conductive members are not left in a high temperature environment in operation, thus preventing the deterioration of elasticity of the conductive members.

Moreover, use of the conductive members eliminates the necessity for the solder bonding of the first electrodes and the thermoelectric elements.

Moreover, since the conductive members have elasticity, variations in height among the thermoelectric elements are accommodated by the conductive members.

Here, in order to prevent the thermoelectric elements from coming into contact with each other, it is desirable that an insulating member is placed in a space between the thermoelectric elements. Moreover, it is desirable that the coupling member is formed using the same metal material as that of the lid.

### BRIEF DESCRIPTION OF THE DRAWINGS

Fig. 1 is a cross-sectional view showing the constitution of a thermoelectric device according to an embodiment.
Fig. 2 is a cross-sectional view showing a state in which first electrodes are formed on a heat radiation-side insulating substrate in a process of manufacturing the thermoelectric device.
Fig. 3 is a cross-sectional view showing a state in which frames are soldered on the heat radiation-side insulating substrate in the process of manufacturing the thermoelectric device.
Fig. 4 is a cross-sectional view showing a state in which grid-like insulating members for specifying the positions of thermoelectric elements are placed on the heat radiation-side insulating substrate in the process of manufacturing the thermoelectric device.
Fig. 5 is a cross-sectional view showing a state in which metal fiber nets are placed in respective cells of the grid partitioned with the insulating members in the process of manufacturing the thermoelectric device.
Fig. 6 is a cross-sectional view showing a state in which the thermoelectric elements are respectively placed on the metal fiber nets in the cells of the grid in the process of manufacturing the thermoelectric device.
Fig. 7 is a schematic plan view showing a state in which the thermoelectric elements are respectively placed on the metal fiber nets in the cells of the grid in the process of manufacturing the thermoelectric device.
Fig. 8 is a cross-sectional view showing a state in which second electrodes and a heat absorption-side insulating substrate are placed on the thermoelectric elements in the process of manufacturing the thermoelectric device.
Fig. 9 is a cross-sectional view showing a state in which a lid is attached to the frame by applying pressure from above the heat absorption-side insulating substrate in the process of manufacturing the thermoelectric device.

### DESCRIPTION OF THE EMBODIMENT

Hereinafter, an embodiment of the present invention will be described with reference to the accompanying drawings.

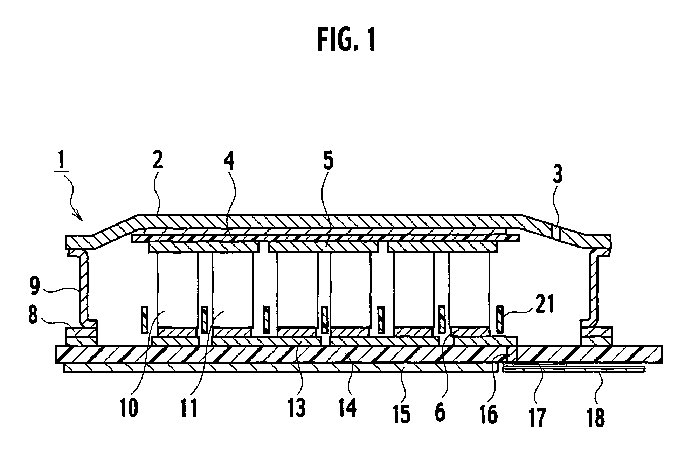

As shown in the cross-sectional view of Fig. 1, a thermoelectric device 1 according to the present embodiment has a plurality of p-type thermoelectric elements 10 and a plurality of n-type thermoelectric elements 11, and is provided with a plurality of first electrodes 13 arranged in the form of an array on the plane surface of a heat radiation-side insulating substrate 14. On the first electrodes 13, metal fiber nets 6 are placed as conductive members which have elasticity in the thickness direction.

Each of thermoelectric elements 10 and 11 is placed respectively so that one end face thereof is in contact with this metal fiber net 6. Second electrodes 5 are placed respectively on the other end faces of each of the thermoelectric elements 10 and 11 in contact therewith. A heat absorption-side insulating substrate 4 is placed on the top faces of the second electrodes 5.

A frame 9 is fixed to the peripheral portion of the surface of the insulating substrate 14 with brazing material 8. A lid 2 is placed in such a manner that pressure is applied from above the insulating substrate 4, and the edge portions of the lid 2 are fixed to the frame 9.

That is, the lid 2 and the heat radiation-side insulating substrate 14 are placed so as to be face to face with each other by keeping a distance, with the second electrodes 5, the thermoelectric elements 10 and 11, and the first electrodes 13 interposed therebetween. Additionally, pressure is to be applied in the longitudinal direction of the thermoelectric elements 10 and 11, i.e., in the direction in which currents flow with the occurrence of electromotive forces. Further, the frame 9 plays a role in specifying a relative position between the insulating substrate 14 and the lid 2.

With the above-described constitution, variations in length among the thermoelectric elements 10 and 11 are accommodated by the metal fiber nets 6. Accordingly, stable conduction can be achieved for the thermoelectric elements 10 and 11 in operation without the steps of selection depending on length and testing. Moreover, the metal fiber nets 6 are placed, not between the thermoelectric elements 10, 11 and the second electrodes 5 on the heat absorption side where the temperature is higher in operation, but between the thermoelectric elements 10, 11 and the first electrodes 13 on the heat radiation side where the temperature is lower, so as not to lose the elasticity of the metal fiber nets 6.

Insulating members 21 are placed respectively in each space between the thermoelectric elements 10 and 11. This insulating members 21 prevent the thermoelectric elements from coming into contact with each other.

The frame 9 is formed using the same metal material as that of the lid 2. This prevents the occurrence of a difference in thermal expansion coefficient between the frame 9 and the lid 2, and prevents the occurrence of damage in the junction between the frame 9 and the lid 2 due to thermal expansion in operation.

On the heat absorption-side insulating substrate 4, a copper film is formed on the entire surface thereof opposite to the side which is in contact with the second electrodes 5, thus increasing the heat absorption efficiency.

The whole of the thermoelectric device 1 is a box structure sealed with the lid 2, the frames 9, and the insulating substrate 14. The inside of the box structure is set to a reduced-pressure atmosphere so that the deformation or destruction of the structure does not easily occur even if the structure suffers a large temperature change, and is hermetically sealed by means of the box structure in order to maintain this atmosphere.

Electromotive forces occurred in the thermoelectric elements 10 and 11 are extracted to the outside by way of a conducting line sealed in a through hole 16 which is formed to penetrate the insulating substrate 14. The conducting line exposed in the principal plane of the through hole 16 which faces the outside is connected by means of solder 17 to an external electrode 18 placed on the insulating substrate 14. Further, a metal coating 15 for increasing heat radiation properties is formed on the outer surface of the insulating substrate 14.

In the present embodiment, the operating temperature of the thermoelectric device on the high temperature side (heat absorption side) is set to 600 °C. As the thermoelectric elements 10 and 11, p-type and n-type thermoelectric elements having the skutterudite structure are used, respectively. On the other hand, the operating temperature on the low temperature side (heat radiation side) is set to 200 °C. For the first electrodes 13, copper is used. For the insulating substrate 14, a Si₃N₄-based ceramic substrate is used. Each of the thermoelectric elements 10 and 11 generates electric power in accordance with the temperature difference between the heat absorption side and the heat radiation side.

Here, the p-type and the n-type of the thermoelectric elements mean thermoelectric elements configured so that the directions in which currents occur when heat is applied are opposite to each other in relation to the direction of a heat gradient. In the present thermoelectric device, the voltages of electromotive forces are to be increased by connecting the p-type thermoelectric elements 10 and the n-type thermoelectric elements 11 in series electrically by the first and second electrodes 13 and 5.

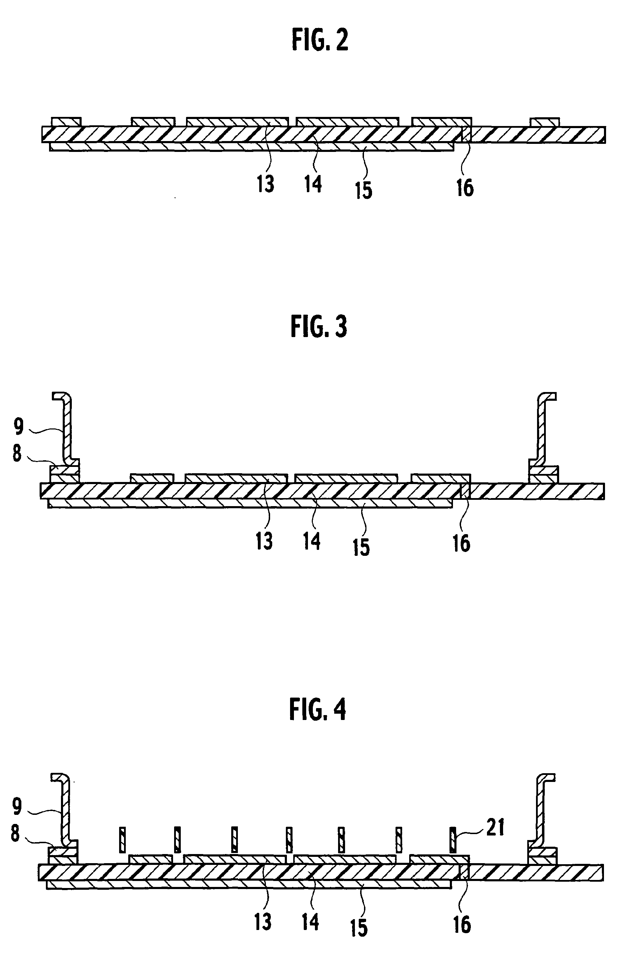

Next, one example of a process of manufacturing the thermoelectric device will be described. As shown in Fig. 2, first, the insulating substrate 14 having the plurality of first electrodes 13 formed on the plane principal surface thereof is prepared.

As shown in Fig. 3, the frame 9 made of Kovar is bonded to the first electrodes 13 at the edge portions of the insulating substrate 14 using the brazing material 8. As the brazing material 8, for example, silver wax is used. It is desirable to select materials for the frame 9 and the insulating substrate 14 with consideration given to the balance among heat emission efficiency, thermal insulation performance, and sealing performance. However, any material can be used as long as the material does not significantly lower the electric power generation performance of the thermoelectric device.

Material for the brazing material 8 is not particularly limited, as long as the bonding strength thereof does not easily decrease in the operating temperature of the thermoelectric device and a state in which Kovar and the first electrodes 13 are bonded together can be maintained.

It is desirable to perform bending on the frame 9 at both ends in the height direction, i.e., at the junctions with the lid 2 and the heat radiation-side insulating substrate 14. With the above-described constitution, a fillet is formed in the bending portion of one end portion of the frame 9, when the one end portion of the frame 9 and the insulating substrate 14 are brazed together. Accordingly, the bonding strength can be increased. On the other hand, for the bonding between the bending portion of the other end portion of the frame 9 and the lid 2, the contact area between the frame 9 and the lid 2 can be increased by performing laser welding. Thus, the bonding strength can be easily increased in both of soldering and laser welding, by performing bending on the junctions at both ends of the frame 9 made of metal. As a result, the thickness of the frame 9 can be thinned.

Subsequently, as shown in Fig. 4, the insulating members 21 for specifying the positions of the thermoelectric elements are placed. For the insulating member 21, a substance obtained by processing an Al₂O₃ member into a grid pattern is used.

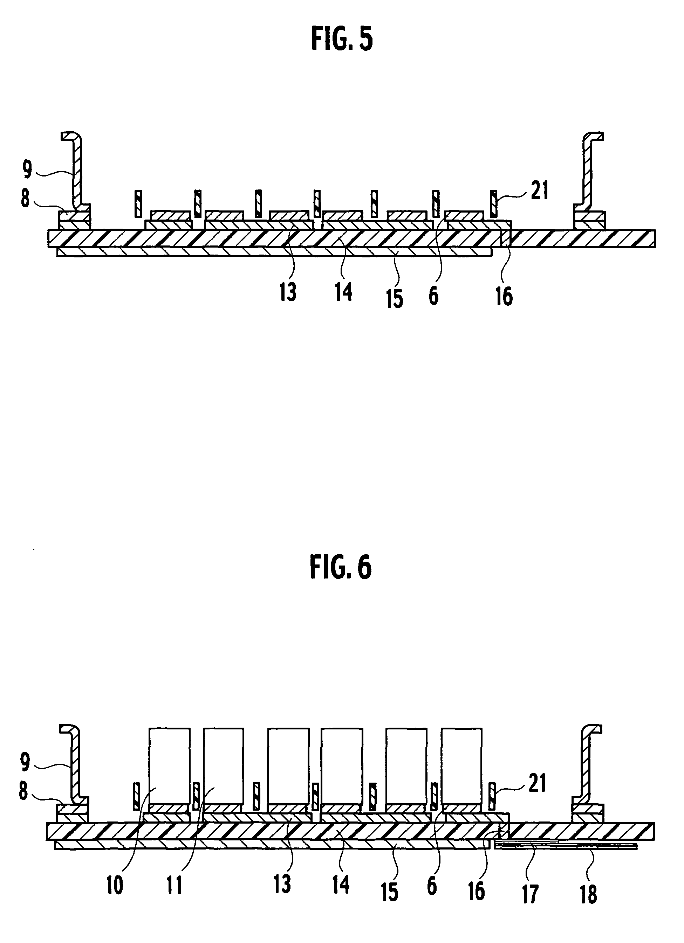

Thereafter, as shown in Fig. 5, the metal fiber nets 6 are respectively placed in the cells of the grid on the first electrodes 13, cells being partitioned with the insulating members 21. For the metal fiber nets 6, a substance obtained by knitting fine copper wires having diameters of 0.6 mm into a mesh.

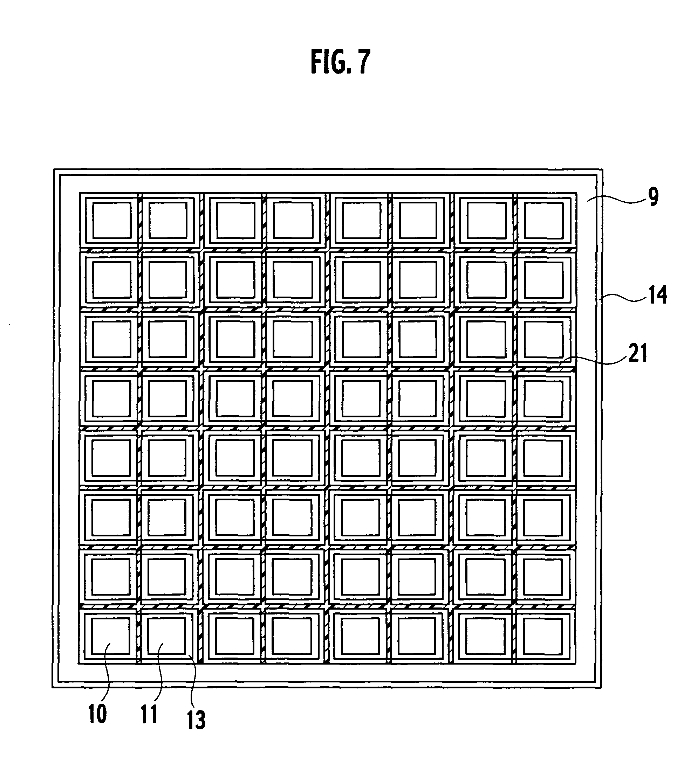

Next, as shown in Fig. 6, the thermoelectric elements 10 and 11 are alternately placed on the metal fiber nets 6 in the respective cells of the grid. Copper thin films are deposited on the heat radiation-side end faces and the heat absorption-side end faces of the thermoelectric elements 10 and 11, in order to reduce contact thermal resistance and electric resistance to the first and second electrodes. The film thickness of each copper thin film is set to approximately 20 *µ*m in total by, for example, depositing a film having a thickness of 2 *µ*m by a sputtering method and then depositing a film having a thickness of 18 *µ*m by electroplating. Incidentally, the processing of the end faces of the thermoelectric elements is not particularly limited as long as the processing is less prone to impair the performances of the thermoelectric elements. The state viewed from the above at this time is as shown in the plan view of Fig. 7.

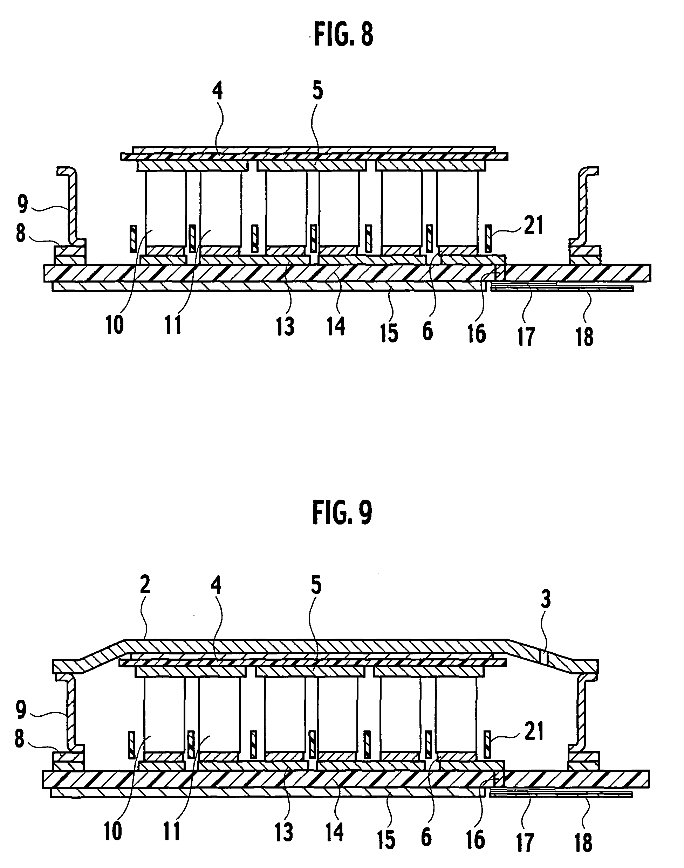

Subsequently, as shown in Fig. 8, the plurality of second electrodes 5 are placed on the thermoelectric elements 10 and 11 in contact therewith. Further, the insulating substrate 4 is placed on the resultant structure in contact therewith.

Then, as shown in Fig. 9, the lid 2, in which a sealing hole 3 penetrating from the front to the back is provided, is placed on the heat absorption-side insulating substrate 4, and the edge portions of the lid 2 and the end portion of the frame 9 are welded with pressure applied from the above. In the present embodiment, Kovar is used as raw material for the lid 2, in order to reduce the differences in thermal expansion with the frame 9 and the insulating substrate 14, while ensuring predetermined heat absorption performance.

As described previously, the present thermoelectric device has a constitution in which the operating temperature on the high temperature side is set to 600 °C and in which p-type and n-type thermoelectric elements having the skutterudite structure are used as thermoelectric elements. However, in an atmospheric environment at 600 °C, the performance may be lowered because the thermoelectric elements having the skutterudite structure are oxidized.

In this connection, in order to prevent such oxidation, the thermoelectric device is formed into a hermetically sealed structure in the last step of the manufacturing process. Specifically, the thermoelectric device 1 is left in a reduced-pressure atmosphere, the sealing hole 3 is melted using a laser to be closed, and an interconnection connected to the first electrodes 13 is extracted to the outside through the through hole 16 provided in the insulating substrate 14, thus obtaining a thermoelectric device having a hermetically sealed structure.

Accordingly, in the present embodiment, the metal fiber nets 6 are placed as conductive members between the first electrodes 13, which are placed on the heat radiation side where the temperature is lower, and the thermoelectric elements 10 and 11, so that the conductive members are not left in a high temperature environment in operation, thus preventing the deterioration of elasticity of the conductive members. This makes it possible to increase the reliability of a slidable structure.

In the present embodiment, use of the metal fiber nets 6 eliminates the necessity for the solder bonding of the first electrodes 13 and the thermoelectric elements 10 and 11. Thus, the productivity of the thermoelectric device can be increased.

In the present embodiment, since the conductive members have elasticity in the height direction of the thermoelectric elements, variations in height among the thermoelectric elements are accommodated by the conductive members. Thus, even if each component is thermally deformed, variations in performance can be reduced.

In the present embodiment, since the insulating member 21 for specifying the positions of the thermoelectric elements 10 and 11 is placed in the space between the adjacent thermoelectric elements, the thermoelectric elements can be prevented from coming into contact with each other even if an unintentional impact is given to the thermoelectric elements. Moreover, the insulating member 21 makes it possible to prevent the thermoelectric elements from being detached from the second electrodes.

In the present embodiment, since the same metal as that of the lid 2 is adopted as the material of the frame 9, the thermal expansion coefficient of the frame 9 and that of the lid 2 are equal to each other. Thus, it is possible to prevent damage due to thermal expansion in operation from occurring in the junction between the frame 9 and the lid 2.

In the present embodiment, a slidable holding structure is adopted in which the second electrodes 5 to be attached to the heat absorption faces of the plurality of p-type and n-type thermoelectric elements 10, 11 are not fixed to the thermoelectric elements 10, 11 and the insulating substrate 4 but just brought into contact therewith. This allows sliding to occur on the contact surface between the respective thermoelectric elements 10, 11 and the second electrodes 5, and makes it possible to prevent the occurrence of breakage and the like of the respective thermoelectric elements, even if the thermoelectric elements 10 and 11, the second electrodes 5, and the insulating substrate 4 are respectively thermally expanded at different ratios. Thus, it is possible to provide a thermoelectric device having more excellent reliability than heretofore.

In the present embodiment, since the thermoelectric device has a hermetically sealed structure, a reduced-pressure atmosphere in the interior can be realized. Thus, it is possible to prevent deterioration due to oxidation in the contact portions between the internal thermoelectric elements and respective components and to provide a thermoelectric device having high reliability. Moreover, this allows the thermoelectric device to be installed in any place.

## Claims

1. A thermoelectric device comprising:
an insulating substrate having a plurality of first electrodes;
a plurality of conductive members placed on the first electrodes, each conductive member having elasticity;
a plurality of thermoelectric elements placed in a state where one end faces thereof are in contact with the conductive members respectively;
a plurality of second electrodes placed to come into contact with other end faces of the thermoelectric elements respectively;
a lid configured to hold the first electrodes, the thermoelectric elements, and the second electrodes in a space between the lid and the insulating substrate, the lid being placed to apply pressure from above the second electrodes; and
a coupling member configured to specify a relative position between the insulating substrate and the lid.

2. The thermoelectric device according to claim 1, further comprising: an insulating member placed in a space between the thermoelectric elements.

3. The thermoelectric device according to claims 1 or 2, wherein the coupling member is formed using the same metal material as that of the lid.
